# EUROPÄISCHE PATENTSCHRIFT

(11) **EP 0 463 230 B1**
(45) Veröffentlichungstag und Bekanntmachung des Hinweises auf die Patenterteilung: **07.12.1994**
(21) Anmeldenummer: 90123712.3
(22) Anmeldetag: 10.12.1990
(51) Int. Cl.: C23C 14/32, C23C 14/50, H01J 37/32, H05H 1/50

(54) **Vorrichtung zum Beschichten von Substraten**
Device for coating substrates
Appareil pour le revêtement de substrats

(30) Priorität: 21.08.1990 DE 4026367; 25.06.1990 DE 4020158
(43) Veröffentlichungstag der Anmeldung: 02.01.1992
(73) Patentinhaber: LEYBOLD AKTIENGESELLSCHAFT, D-63450 Hanau (DE)
(72) Erfinder: Betz, Hans-Georg, Dr., W-6454 Bruchkoebel 4 (DE); Campbell, Gregor A., Glendale, CA 91202 (DE); Conn, Robert W., Los Angeles, CA 90025 (US); Matl, Karl, Dr., W-8752 Kleinostheim (DE); Sommerkamp, Peter, Dr., W-6450 Hanau (DE); Zoeller, Alfons, W-6483 Bad Soden-Salmuenster (DE); Goebel, Dan M., Tarzana, CA 91356 (US)

(56) Entgegenhaltungen:
- EP-A- 0 269 446
- EP-A- 0 308 680
- DE-A- 2 612 098
- FR-A- 950 651
- IBM TECHNICAL DISCLOSURE BULLENTIN, Bd. 26, Nr. 11, 1. April 1984, NEW YORK, Seiten 6154-6155; R.J.B. ESCHBACH: "Evaporation system with RF clean"
- PATENT ABSTRACTS OF JAPAN, vol. 7, no. 285 (C-201)(1430), 20. Dezember 1983; & JP-A-58 164 782

## Beschreibung

Die Erfindung betrifft eine Vorrichtung zum Beschichten von Substraten in einer Vakuumkammer mit einem in dieser angeordneten Substratträger und einer Einrichtung zur Erzeugung einer Plasmawolke, die einen Elektronen-Emitter mit einer nachgeschalteten rohrförmigen Anode aufweist, die mit einem Einlaß für das Prozeßgas zum Zünden des Plasmas versehen ist und die weiterhin mit Magneten ausgestattet ist, wobei in der Prozeßkammer eine Vorrichtung zur Erzeugung von Atomen, Molekülen oder Clustern der Materialien zur Erzeugung der Schicht auf den Substraten, vorzugsweise ein Elektronenstrahlverdampfer, ein thermischer Verdampfer oder eine Sputterkathode, dem Substrathalter gegenüberliegend, angeordnet ist, von der aus das verdampfte oder abgestäubte Material direkt auf die Substrate aufbringbar ist.

Es ist bereits ein Plasmagenerator mit Ionenstrahlerzeuger bekannt (Aufsatz von D. M. Goebel, G. Campbell und R. W. Conn im "Journal of Nuclear Material", 121 (1984), 277 - 282, North Holland Physics Publishing Division, Amsterdam), der in einer mit der Vakuumkammer verbundenen, separaten Kammer angeordnet ist, wobei die etwa zylindrische Kammerwand dieser separaten Kammer die Anode bildet, und mit einem Einlaßstutzen für das Prozeßgas versehen ist. Die zylindrische Kammer ist von ringförmigen Magnetspulen und mit Rohren zur Kühlung der Kammerwand versehen. Der Elektronen-Emitter selbst befindet sich an einem das eine Ende der zylindrischen Kammer verschließenden, dem eigentlichen Vakuumkessel abgekehrten Wandteil.

Weiterhin ist eine Kathodenzerstäubungsvorrichtung bekannt (DE-OS 38 30 478), bei der die Vakuumkammer mit einer Einrichtung zur Erzeugung eines Plasmastrahls verbunden ist und ein Target aufweist, das mit Magneten zusammenwirkt, die den Plasmastrahl auf die Oberfläche des Targets lenken, und mit einer Einrichtung versehen ist, um Ionen im Plasmastrahl zu beschleunigen, die die Oberfläche des Targets treffen und Teilchen herauslösen und die einen Substrathalter aufweist, der im Inneren der Vakuumkammer zur Halterung der Substrate für die Beschichtung mit abgestäubten Teilchen angeordnet ist und vorzugsweise mit einer Einrichtung, beispielsweise einer Magnetanordnung, ausgestattet ist für die Ablenkung eines Fadens oder Teilstrahls des Plasmastrahls vom Target auf das Substrat.

Schließlich ist eine Vorrichtung zum Beschichten von Substraten in einer Vakuumkammer bekannt (EP-A-0 269 446), die einen Substratträger und dem gegenüberliegend eine Plasmaquelle und einen Elektronenstrahlverdampfer umfaßt, wobei die Plasmaquelle selbst außerhalb der eigentlichen Prozeßkammer so angeordnet ist, daß ihre rohrförmige Anode in diese einmündet und die die Anode umschließende Magnetspule sich außerhalb der Prozeßkammer befindet.

Der vorliegenden Erfindung liegt die Aufgabe zugrunde, eine Vorrichtung zum Beschichten metallischer oder dielektrischer Werkstoffe mit Hilfe eines fremderzeugten Plasmas zu schaffen, bei der die Gleichmäßigkeit der Beschichtung besonders höchsten Ansprüchen genügt, deren Aufbau einfach ist, in welcher die Plasmaerzeugung unabhängig von der Erzeugung des Beschichtungsmaterials erfolgt und bei der die einzelnen Parameter voneinander unabhängig einstellbar sind. Außerdem soll die beschichtbare Substratgröße möglichst frei bestimmbar und die für eine gleichmäßige Beschichtung erforderliche Dichteverteilung des Plasmas genau einstellbar sein.

Schließlich soll eine zusätzliche Ionisierung des Aufdampfmaterials möglich sein, um die Schichteigenschaften weiter erhöhen zu können.

Diese Aufgabe wird erfindungsgemäß dadurch gelöst, daß die die rohrförmige Anode der unmittelbar neben dem Verdampfer auf derselben Seite der Prozeßkammer angeordneten Quelle umschließende Magnetanordnung zur Abschirmung von Streumagnetfeldern von einem Abschirmrohr und zur Unterdrückung von Nebenplasmen von einer Dunkelraumabschirmung umschlossen ist, und die aus der Anode austretende Plasmawolke auf den der Quelle gegenüberliegend angeordneten Substratträger lenkt, wobei mit Hilfe von auf der der Quelle abgewandten Seite des Substratträgers angeordneten Magneten eine für eine gleichmäßige Beschichtung erforderliche Dichteverteilung des Plasmas bewirkbar ist. Eine weitere Vorrichtung ist im Anspruch 8 definiert.

Weitere Einzelheiten und Merkmale sind in den Unteransprüchen beschrieben und gekennzeichnet.

Die Erfindung läßt die verschiedensten Ausführungsmöglichkeiten zu; zwei davon sind in den anhängenden Zeichnungen näher dargestellt, die den Aufbau zweier erfindungsgemäßer Vorrichtungen rein schematisch näher darstellen.

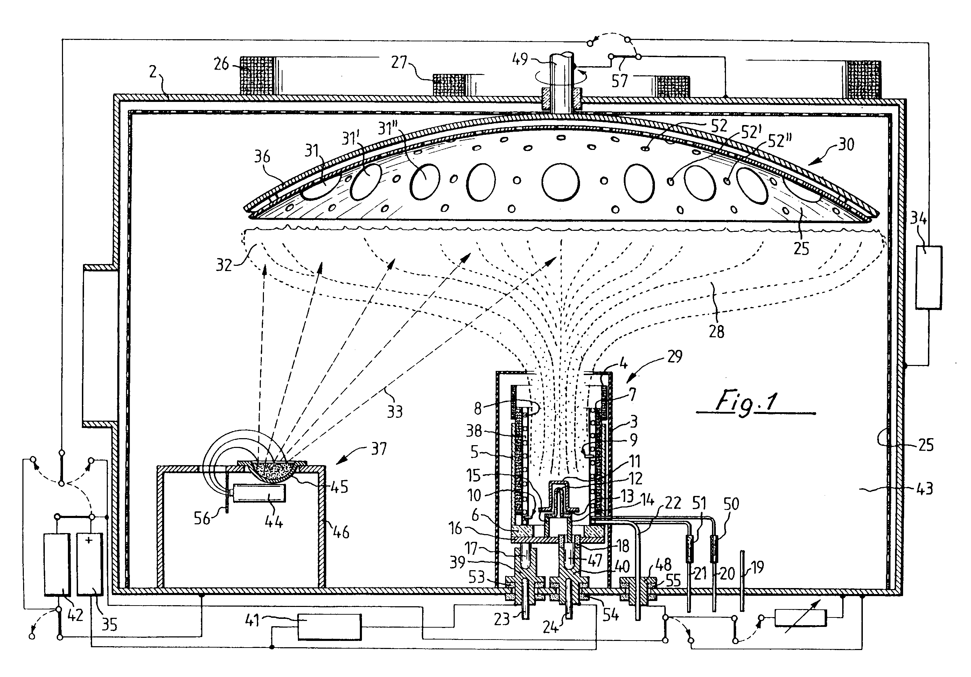

Figur 1 betrifft eine Vorrichtung und ein Verfahren zur Modifizierung von Schichteigenschaften von dünnen Schichten, die isolierend oder metallisch sein können. Das Aufbringen solcher dünnen Schichten auf die vom Substratträger 30 gehaltenen Substrate 31, 31', ... kann durch Verdampfen oder durch Sputtern in der Vakuumkammer 2 erfolgen. Das Verfahren selbst umfaßt einen plasmagestützten Prozeß, bei dem die Schichteigenschaften der aufwachsenden dünnen Schicht durch Ionenbeschuß aus einer Plasmarandschicht 32 modifiziert werden.

Die in Figur 1 dargestellte Vorrichtung umfaßt eine insgesamt mit 29 bezeichnete Plasmaquelle (APS-Quelle), in der das benötigte Plasma 28 erzeugt wird und mit Hilfe geeigneter magnetischer und elektrischer Felder aus der Quelle 29 extrahiert wird.

Nach der Extraktion aus der Quelle 29 wird das Plasma 28 mit Hilfe geeigneter magnetischer Felder von der Quelle 29 zum Substratträger 30 geführt, aufgeweitet und möglichst homogen auf den Bereich des Substratträgers 30 verteilt. Die Ionen des Plasmas 28 werden von Ionen der über die Leitungen 20, 21 in die Plasmaquelle 29 eingeführten Gase gebildet bzw. sind aus dem ionisierten Aufdampfmaterial 33 bzw. vom Sputtermaterial abgespalten, welches das Plasma 28 durchquert und hierbei ionisiert wird.

Der Substrathalter 30 ist entweder isoliert zur Vakuumkammer 2 oder über den Schalter 57 an ein DC- (35, 42) oder (und) HF-Netzgerät 34 angeschlossen. Dieser Substrathalter 30 kann einen Bedampfungsschutz 25 aufweisen, der beim Aufbringen von isolierenden Materialien das Beschichten eines Teils der Fläche des Substratträgers 30 mit diesen isolierenden Materialien verhindert und damit ein Abfließen von elektrischen Ladungen über den Substratträger 30 ermöglicht.

Die Vakuumanlage ist weiterhin mit einer Vorrichtung zur Erzeugung von Atomen bzw. Molekülen oder Clustern der Materialien zur Erzeugung der dünnen Schichten ausgestattet. Dies ist im beschriebenen Falle der Elektronenstrahlverdampfer 37. Es kann jedoch auch ein thermischer Verdampfer, eine HF- oder DC-Sputterkathode oder eine Ionenstrahl-Sputterkathode sein.

Die Vakuumanlage weist Gaseinlässe 19 zum Einlassen von reaktiven Gasen, z. B. O₂ und N₂, auf und umfaßt ein System von elektromagnetischen Spulen 4, 7 bzw. 26, 27 zur Führung des Plasmas 28 von der Plasmaquelle 29 zum Substrathalter 30 und zur Erzeugung einer geeigneten Dichteverteilung des Plasmas am Ort des Substrathalters 30.

Die Vakuumanlage beinhaltet auch einen Satz von Bedampfungsschutzblechen 25, die beim Aufbringen von isolierenden Materialien ein Abfließen von Ladungsträgern ermöglichen.

Zur Vorrichtung gehört die insgesamt mit 29 bezeichnete Plasmaquelle (APS-Quelle) zur Erzeugung der Plasmawolke 28 zur Modifizierung der Schichteigenschaften der dünnen Schichten.

In dieser Plasmaquelle 29 wird zur Erzeugung des Plasma 28 eine heiße Glimmentladung erzeugt. Die Plasmaquelle 29 besitzt dazu eine relativ zur Anlage isolierte Kathode 11. Die Kathode 11 ist mit einem Heizer 12, z. B. aus Graphit, versehen, der mit einem Wechselstrom geheizt wird. Der Heizer 12 heizt indirekt über Wärmestrahlung die Kathode 11. Die Kathode 11 besteht aus einem Material, welches im heißen Zustand die Emission von Elektronen ermöglicht, so z. B. Lanthanhexaborid (LaB₆). Die Kathode 11 selbst besteht aus einem zylindrischen und einem deckelförmigen Teil, so daß die Emission von Elektronen sowohl in radialer als auch axialer Richtung relativ zur Achse der Quelle, im dargestellten Falle also in vertikaler Richtung, möglich ist.

Die Plasmaquelle 29 ist außerdem mit einem relativ zur Anlage und zur Kathode 11 isolierten Anodenrohr 38 versehen, das z. B. mit einer von Wasser durchströmten Kühlschlange 8 ausgestattet ist. Der Fluß des elektrischen Stromes erfolgt ebenfalls über das zur Anlage isolierte Kühlmittelrohr 22.

Das Prozeßgas selbst kann ein Edelgas sein, z. B. Ar, oder ein Reaktivgas, z. B. O₂, oder ein Gemisch von beiden. Die beiden Gaszuführungen 20, 21 sind von der Anlage selbst elektrisch isoliert.

Weiterhin ist die Plasmaquelle 29 mit zwei wassergekühlten Hochstromdurchführungen 39, 40 und einem langen Solenoidmagneten 7, der über das Anodenrohr 38 geschoben ist, ausgestattet, wobei dieser ein axiales Magnetfeld parallel zur vertikalen Achse der Quelle 29 erzeugt.

Mit dem Magneten 7 wird die Beweglichkeit der Elektronen in radialer Richtung stark erniedrigt und in vertikaler Richtung stark erhöht. Am oberen Ende des langen Solenoids 7 ist ein kurzer Solenoid 4 angeordnet, der das Magnetfeld am Ende des langen Solenoiden 7 verstärkt. Das Magnetfeld wird auf diese Weise homogener, da das axiale Magnetfeld eines Solenoiden von seiner Mitte zum Ende hin bis auf die Hälfte abnimmt. Die Extraktion des Plasmas 28 aus der Quelle 29 in die Vakuumanlage wird also durch die geschilderte Anordnung verbessert.

An der Plasmaquelle 29 ist über den langen Solenoiden 7 ein zylindrisches Abschirmrohr 5 aus weichmagnetischem Material geschoben. Dieses Abschirmrohr 5 dient zum Abschirmen von Streumagnetfeldern, die sich innerhalb der Anlage befinden können (verursacht z. B. durch Elektronenstrahlverdampfer), damit das Plasma 28 innerhalb der Quelle 29 nicht gestört wird. Die Plasmaquelle 29 ist darüber hinaus noch mit einer Dunkelraumabschirmung 3 versehen, die dafür Sorge trägt, daß nicht außen an der Quelle 29 unerwünschte Nebenplasmen entstehen.

Die Plasmaquelle 29 und der Substrathalter 30 sind jeweils an die Netzgeräte 34, 35, 42 anschließbar, durch das die Funktionsweise der Plasmaquelle 29 und die Eigenschaften des Plasmas 28 bestimmbar sind. Außerdem ist ein besonderes Heizungsnetzgerät 41 für den Heizer 12 der Kathode 11 vorgesehen.

Weiterhin besitzt die Plasmaquelle 29 eine Stromversorgung 35 für den Entladungsstrom, mit dem die Potentialdifferenz zwischen der Kathode 11 und der Anode 38 bzw. 30 bzw. 2 festgelegt wird.

Schließlich ist die Plasmaquelle 29 mit einer Spannungsversorgung 42 versehen, die es ermöglicht, eine "Bias"Potentialdifferenz z. B. zwischen der Plasmaquelle 29 und der Anlage 2 oder dem Substrathalter 30 anzulegen. Damit ist es möglich, das Plasmapotential und die Energie der auf die Substrate 31, 31', ... auftreffenden Ionen zu beeinflussen.

Der Substrathalter 30 ist mit einer Hochfrequenz-Spannungsversorgung 34 ausgestattet, mit der es möglich ist, auch isolierende Substrate 31, 31', ... eine zusätzliche DC-Bias-Spannung relativ zum Plasma 28 zu bringen und damit die Energie und Stromstärke der auf die Substrate 31, 31', ... auftreffenden Ionen zu erhöhen.

Bei der dargestellten Verschaltung arbeitet die Quelle als eine "Reflex-Arc"-Quelle. Das Anodenrohr 38 ist direkt mit dem Pluspol der Entladungsversorgung 35 verbunden, so daß der Entladungsstrom nur über das Anodenrohr 38 abfließen kann. Die Plasmaquelle 29 ist gegenüber den übrigen Teilen der Anlage isoliert angeordnet. Die Elektronen, die aus der Kathode 11 austreten, werden durch das axiale Magnetfeld der Solenoidmagneten 7 gehindert, direkt zum Anodenrohr 38 zu gelangen. Vielmehr folgen sie den Magnetfeldlinien und gelangen so aus der Quelle 29 heraus und erzeugen ein Plasma 28 außerhalb der Quelle. Die gesamte Quelle 29 stellt sich dazu auf ein positives Potential relativ zu den übrigen Teilen der Anlage ein, was dazu führt, daß sich ein elektrisches Feld aufbaut, das bewirkt, daß die Elektronen außerhalb der Quelle reflektiert werden und entlang der Feldlinien zum Anodenrohr 38 zurücklaufen.

Bei dieser Betriebsart lädt sich der Substrathalter 30 nicht auf ein negatives Bias-Potential auf, wie z. B. bei einem Ion-planting-Verfahren. Der Substrathalter 30 lädt sich typischerweise auf +2 V bis +5 V auf, wobei die Ionen ihre Energie über die Potentialdifferenz zwischen dem Anodenrohr 38 und dem Substrathalter 30 erhalten.

### Typische Werte hierfür sind:

| | |
|---|---|
| Pₐᵣ | = 2 . 10⁻⁴ mbar durch die Quelle |
| Pₒ₂ | = 4 . 10⁻⁴ mbar durch die Anlage |
| U_{Kathode-Anode} | = 60 V |
| U_{Anode-Anlage} | = +75 V |
| I_{Entladung} | = 45 A |

Wie aus der Zeichnung ersichtlich, ruhen sowohl das Anodenrohr 38 als auch die hohlzylindrische Magnetfeldabschirmung 5 auf dem aus Keramik bestehenden Isolatorplatte 6, der seinerseits auf der aus Kupfer bestehenden Kontaktplatte 16 abgestützt ist.

Der Heizer 12 ist mit Hilfe eines Klemmrings 13 mit dem hutförmigen Elektronen-Emitter 11 fest verbunden, wobei zwei Kontaktbolzen 14, 15 vorgesehen sind, mit denen der Heizer 12 einerseits auf der Kontaktplatte 16 und andererseits auf dem Kontaktzapfen 47 abgestützt ist.

Die Kontaktplatte 16 ist über den Zapfen 17 mit der Hochstromdurchführung 39 verbunden, die mit Hilfe des Isolators 53 an der Wand der Vakuumkammer 2 gehalten ist und der außerdem ein wasserdurchströmtes Kühlmittelrohr 23 aufweist. Die Kontaktplatte 16 ist mit Hilfe eines Keramikrings 18 gegenüber der Hochstromdurchführung 40 elektrisch isoliert, die ebenfalls mit einem Kühlmittelrohr 24 versehen ist und die über den Zapfen 47 elektrisch leitend an dem Kontaktbolzen 14 anliegt. Die Hochstromdurchführung 48 ist mit dem Isolator 55 am Bodenteil der Vakuumkammer gehalten und umschließt das wasserdurchströmte Kühlmittelrohr 22, das im übrigen mit dem DC-Netzgerät 35 verbunden ist. Die Rohre 20, 21 sind mit den Einlaßstutzen 9 bzw. 10 verbunden und weisen beide ein elektrisch isolierendes Schlauchzwischenstück 50 bzw. 51 auf.

Der seitlich neben der Plasmaquelle 29 am Bodenteil der Vakuumkammer 2 angeordnete Verdampfer 37 besteht aus einem Verdampfergestell 46, einem von diesem an seiner Oberseite gehaltenen Tiegel 45 mit dem zu verdampfenden Beschichtungswerkstoff, einer Elektronenstrahlkanone 44 zum Aufschmelzen und Verdampfen des Werkstoffs und einer Blende 56 für die Ausrichtung der Elektronenstrahlung.

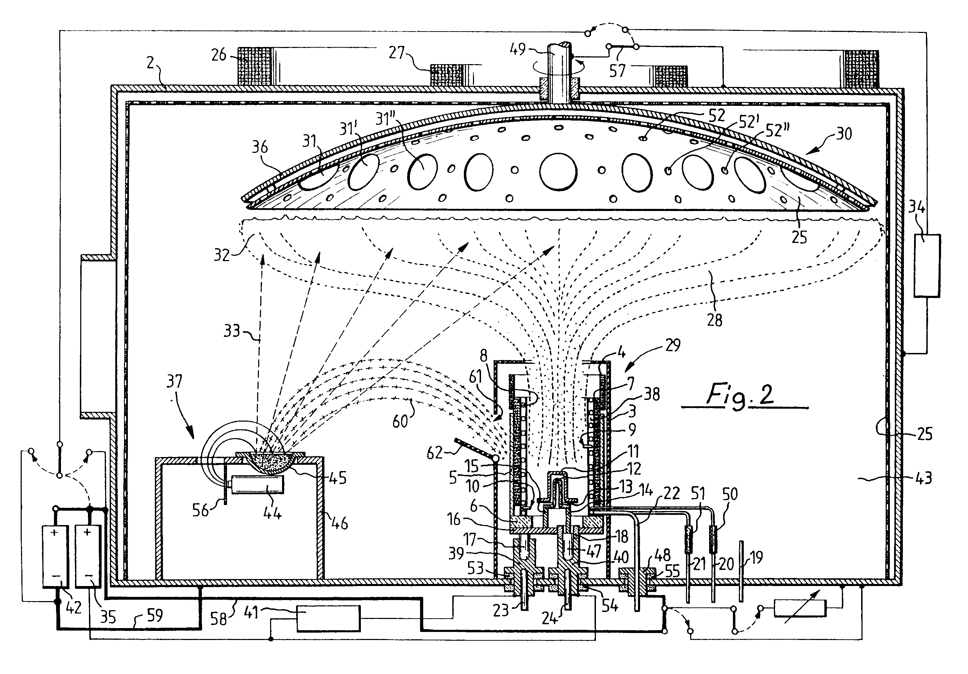

Verwendet man also zum Aufdampfen einen Elektronenstrahlverdampfer 37, so wird das zum Aufdampfen im Tiegel 45 vorhandene Material durch den Beschuß mit Elektronen, die mit einer Elektronenstrahlkanone 44 erzeugt werden, eingeschmolzen. Hierbei werden durch den Elektronenbeschuß des zu schmelzenden Materials Sekundärelektronen erzeugt. Verwendet man, wie dies in Figur 2 gezeigt ist, in der Nähe dieses Elektronenstrahlverdampfers 37, der sich auf demselben elektrischen Potential befindet wie die Vakuumkammer 2, z. B. eine APS-Quelle, so kann mit Hilfe dieser Sekundärelektronen ein Plasma zwischen dem Tiegel 45 des Elektronenstrahlverdampfers 37 und dem Anodenrohr 38 der APS-Quelle 29 erzeugt werden, wenn die APS-Quelle 29 und damit das Anodenrohr 38 mit Hilfe eines Bias-Netzgerätes 42 und die Leitungen 58, 59 auf ein relativ zur Anlage positives Potential gelegt wird, während gleichzeitig in der APS-Quelle 29 ein Plasma erzeugt und in die Anlage transportiert wird.

Hierzu ist es notwendig, genau gegenüber dem Elektronenstrahlverdampfer 37 eine Öffnung 61 in der Dunkelraumabschirmung 3 vorzusehen, damit die Elektronen 60, die aus dem Tiegel 45 des Elektronenstrahlverdampfers 37 austreten, auf direktem Wege zu dem Anodenpotential sich befindenden Magnetfeldabschirmrohr 5 gelangen und so das Plasma 60 erzeugen können.

Die über dem Tiegel so erzeugte Plasmawolke führt zu einer zusätzlichen Ionisierung des Aufdampfmaterials.

Dies führt zu einer zusätzlichen Verbesserung der Schichteigenschaften der aufgebrachten dünnen Schichten und zu einer Verbesserung der Verteilung über den Substratträger, da die Ionen durch das Plasma und die in der Anlage vorhandenen magnetischen Felder auf den Substrathalter geführt werden.

Es ist klar, daß in einer besonderen Ausführungsform (nicht näher dargestellt) auch auf die Öffnung 61 verzichtet werden kann. In diesem Falle würde der Plasmastrom 60 vom Tiegel 45 aus von oben her in die obere zentrale Öffnung im Deckelteil der Dunkelraumabschirmung 3 eintreten und direkt zum Anodenrohr 38 gelangen.

### Bezugszeichenliste

- 2: Vakuumkammer
- 3: Dunkelraumabschirmung
- 4: Solenoid, Magnet
- 5: Magnetfeldabschirmung, Abschirmrohr
- 6: Isolatorplatte, Keramikplatte
- 7: Magnet, Solenoid
- 8: Kühlschlange
- 9: Sauerstoff-Einlaß, Einlaßstutzen
- 10: Argon-Einlaß, Einlaßstutzen
- 11: Lanthanhexaborid-Kathode, Elektronen-Emitter
- 12: Graphit-Heizer
- 13: Klemmring (verschraubt mit Heizer 12)
- 14, 15: Stab, Kontaktbolzen
- 16: Kupferplatte, Kontaktplatte
- 17: Zapfen, Kontaktzapfen
- 18: Keramikring
- 19: Sauerstoff und/oder Stickstoff
- 20: Sauerstoff und/oder Stickstoff, elektrisch isoliert
- 21: Argon-Einlaß
- 22, 23, 24: wasserdurchströmtes Kühlmittelrohr
- 25: Lochblech, schirmartiger Blechzuschnitt
- 26, 27: Ringspule, Magnet
- 28: Plasmawolke
- 29: Plasmaquelle
- 30: Substrathalter, Substratträger, Anode
- 31, 31', ...: Substrat
- 32: Plasmarandschicht
- 33: Aufdampfmaterial (Sputtermaterial)
- 34: HF-Netzgerät, HF-Generator
- 35: DC-Netzgerät, Plasmaversorgung
- 36: Bedampfungsschutz, schirmartiger Blechzuschnitt
- 37: Elektronenstrahlverdampfer, Verdampfer
- 38: Anodenrohr
- 39, 40: Hochstromdurchführung
- 41: Stromversorgung
- 42: Spannungsversorgung (für Bias-Spannung)
- 43: Prozeßkammer
- 44: Elektronenstrahlkanone
- 45: Tiegel
- 46: Verdampfergestell
- 47: Zapfen, Kontaktzapfen
- 48: Hochstromdurchführung
- 49: Welle
- 50, 51: Isolierschlauch
- 52, 52', ...: Lochung
- 53, 54, 55: Isolator
- 56: Blende
- 57: Schalter
- 58: elektrische Leitung
- 59: elektrische Leitung
- 60: Plasmastrom, Plasmaentladung
- 61: Öffnung
- 62: Klappe, Bedampfungsschutzblende

## Patentansprüche

1. Vorrichtung zum Beschichten von Substraten (31, 31', ...) in einer Vakuumkammer (2) mit einem in dieser angeordneten Substratträger (30) und einer Einrichtung (29) zur Erzeugung einer Plasmawolke(28), die einen Elektronen-Emitter (11) mit einer nachgeschalteten rohrförmigen Anode (38) aufweist, die mit einem Einlaß (10) für das Prozeßgas zum Zünden des Plasmas versehen ist und die weiterhin mit Magneten (4, 7) ausgestattet ist, wobei in der Prozeßkammer (43) eine Vorrichtung zur Erzeugung von Atomen, Molekülen oder Clustern der Materialien zur Erzeugung der Schicht auf den Substraten (31, 31', ...), vorzugsweise ein Elektronenstrahlverdampfer (37), ein thermischer Verdampfer oder eine Sputterkathode, dem Substrathalter (30) gegenüberliegend, angeordnet ist, von der aus das verdampfte oder abgestäubte Material (31) direkt auf die Substrate (31, 31', ...) aufbringbar ist, **dadurch gekennzeichnet**, daß die die rohrförmige Anode (38) der unmittelbar neben dem Verdampfer (37) auf derselben Seite der Prozeßkammerwand angeordneten Quelle (29) umschließende Magnetanordnung (4, 7) von einem Abschirmrohr (5) und von einer Dunkelraumabschirmung (3) umschlossen ist, und die aus der Anode (38) austretende Plasmawolke (28) auf den der Quelle (29) gegenüberliegend angeordneten Substratträger (30) lenkt, wobei mit Hilfe von auf der der Quelle (29) abgewandten Seite des Substratträgers (30) angeordneten Magneten (26, 27) eine für eine gleichmäßige Beschichtung erforderliche Dichteverteilung des Plasmas (28) bewirkbar ist.

2. Vorrichtung nach Anspruch 1, **dadurch gekennzeichnet**, daß der gegenüber der Prozeßkammerwand (2) elektrisch isoliert angeordnete Substrathalter (30) wahlweise an einen Hochfrequenz-Generator (34) oder an ein DC-Netzgerät (35) anschließbar ist.

3. Vorrichtung nach den Ansprüchen 1 und 2, **dadurch gekennzeichnet**, daß der Substrathalter (30) im wesentlichen aus einem schirmartig ausgeformten, mit einer Vielzahl von Lochungen (52, 52', ...) versehenen Blechzuschnitt gebildet ist, über den mit Abstand ein zweiter, ebenfalls schirmartiger Blechzuschnitt (36) gestülpt ist, wobei beide Blechzuschnitte (25, 36) drehfest mit einer motorisch angetriebenen Welle (49) verbunden sind.

4. Vorrichtung nach einem oder mehreren der vorhergehenden Ansprüche, **dadurch gekennzeichnet**, daß die Innenwand der Prozeßkammer (43) mit Abstand von einem Lochblech (25) bekleidet ist.

5. Vorrichtung nach einem oder mehreren der vorhergehenden Ansprüche, **dadurch gekennzeichnet**, daß ein Plasma (60) zwischen dem Tiegel (45) des Elektronenstrahlverdampfers (37) und dem Anodenrohr (38) der Plasmaquelle (29) durch Anlegen einer Potentialdifferenz zwischen der Plasmaquelle (29) und der Vakuumkammer (2) erzeugbar ist, durch ein DC-Netzgerät (42), welches an die Kathode und die Anode dieser Plasmaentladung angeschlossen ist, derart, daß der Tiegel (45) die Kathode für das Plasma und das Anodenrohr (38) der Plasmaquelle (29) die Anode für das Plasma bildet, wobei dem Tiegel (45) benachbart eine Öffnung (61) in der Dunkelraumabschirmung (3) vorgesehen ist, um eine direkte Verbindung für die Elektronen der Plasmaentladung (60) zur Magnetfeldabschirmung (5) zu schaffen, die ihrerseits leitend mit dem Anodenrohr (38) verbunden ist.

6. Vorrichtung nach einem oder mehreren der vorhergehenden Ansprüche, **dadurch gekennzeichnet**, daß das DC-Netzgerät (42) mit seinem einen Pol über eine erste elektrische Leitung (58) an die Hochstromdurchführung angeschlossen ist, die ihrerseits über ein stromleitendes Kühlmittelrohr (22) mit dem Anodenrohr (38) der Plasmaquelle (29) in Verbindung steht, wobei das DC-Netzgerät (42) mit seinem anderen Pol über eine zweite elektrische Leitung (59) an das Verdampfergestell (46) angeschlossen ist, auf dem sich der Tiegel (45) des Verdampfers (37) abstützt.

7. Vorrichtung nach den Ansprüchen 5 und 6, **dadurch gekennzeichnet**, daß die Öffnung (61) in der Dunkelraumabschirmung (3) von einer Klappe (62) verschließbar ist und das Maschinengestell (46) in elektrisch leitender Verbindung über die Leitung (59) mit der Spannungsversorgung (42) steht.

8. Vorrichtung zum Beschichten von Substraten (31, 31', ...) in einer Vakuumkammer (2) mit einem in dieser angeordneten Substratträger (30) und einer Einrichtung (29) zur Erzeugung einer Plasmawolke (28), die einen Elektronen-Emitter (11) mit einer nachgeschalteten rohrförmigen Anode (38) aufweist, die mit einem Einlaß (10) für das Prozeßgas zum Zünden des Plasmas versehen ist und die weiterhin mit Magneten (4, 7) ausgestattet ist, wobei in der Prozeßkammer (43) eine Vorrichtung zur Erzeugung von Atomen, Molekülen oder Clustern der Materialien zur Erzeugung der Schicht auf den Substraten (31, 31', ...) vorzugsweise ein Elektronenstrahlverdampfer (37), ein thermischer Verdampfer oder eine Sputterkathode, dem Substrathalter (30) gegenüberliegend, angeordnet ist, von der aus das verdampfte oder abgestäubte Material (31) direkt auf die Substrate (31, 31', ...) aufbringbar ist, **dadurch gekennzeichnet**, daß die Einrichtung (29) gegenüber den übrigen Teilen der Vorrichtung elektrisch isoliert im Innenraum der Vakuumkammer (2) dem Substratträger (30) gegenüberliegend angeordnet ist, wobei der Elektronen-Emitter (11) an den einen Pol und das Anodenrohr (38) an den anderen Pol einer Stromquelle (35) anschließbar sind, so daß die aus dem Elektronen-Emitter (11) austretenden und außerhalb der Einrichtung (29) reflektierten Elektronen entlang der Feldlinien der Magnete (4, 7) zum Anodenrohr (38) zurückführbar sind.

## Claims

1. Apparatus for coating substrates (31, 31', ...) in a vacuum chamber (2) having a substrate carrier (30) disposed therein and a device (29) for generating a plasma cloud (28) which comprises an electron emitter (11) with a tubular anode (38) which is connected downstream, which is provided with an inlet (10) for the process gas for igniting the plasma, and which is furthermore equipped with magnets (4, 7), an apparatus for generating atoms, molecules or clusters of the materials for generating the layer on the substrates (31, 31', ...), preferably an electron beam vaporizer (37), a thermal vaporizer or a sputter cathode, being disposed opposite the substrate holder (30) in the process chamber (43), from which apparatus the vaporized or dust-like material (31) can be applied directly onto the substrates (31, 31', ...), characterized in that the magnet arrangement (4, 7) surrounding the tubular anode (38) of the source (29) disposed directly adjacent the vaporizer (37) on the same side of the process chamber wall is surrounded by a screening tube (5) and a darkroom screen (3), and guides the plasma cloud (28) emerging from the anode (38) onto the substrate carrier (30) disposed opposite the source (29), it being possible for a density distribution of the plasma (28) necessary for uniform coating to be brought about by means of magnets (26, 27) disposed on the side of the substrate carrier (30) remote from the source (29).

2. Apparatus according to Claim 1, characterized in that the substrate holder (30) disposed such that it is electrically insulated with respect to the process chamber wall (2) can optionally be connected to a high-frequency generator (34) or to a DC mains apparatus (35).

3. Apparatus according to either of Claims 1 and 2, characterized in that the substrate holder (30) is substantially formed from a sheet metal blank which is formed out in the manner of an umbrella, which is provided with a plurality of holes (52, 52', ...) and over which a second, likewise umbrella-like, sheet metal blank (36) is inverted at a spacing, both sheet metal blanks (25, 36) being connected to a motor-driven shaft (49) such that they are fixed for rotation.

4. Apparatus according to one or more of the preceding claims, characterized in that the inner wall of the process chamber (43) is lined at a spacing by a perforated plate (25).

5. Apparatus according to one or more of the preceding claims, characterized in that a plasma (60) can be generated between the crucible (45) of the electron beam vaporizer (37) and the anode tube (38) of the plasma source (29) by the application of a potential difference between the plasma source (29) and the vacuum chamber (2) by a DC mains apparatus (42) which is connected to the cathode and the anode of this plasma discharge in such a way that the crucible (45) forms the cathode for the plasma and the anode tube (38) of the plasma source (29) forms the anode for the plasma, an opening (61) in the darkroom screen (3) being provided adjacent the crucible (45) in order to provide a direct connection for the electrons of the plasma discharge (60) to the magnetic field screen (5) which is in turn conductively connected to the anode tube (38).

6. Apparatus according to one or more of the preceding claims, characterized in that one pole of the DC mains apparatus (42) is connected by means of a first electric lead (58) to the peak current duct which is in turn connected by means of a current-conducting coolant tube (22) to the anode tube (38) of the plasma source (29), the other pole of the DC mains apparatus (42) being connected by means of a second electric lead (59) to the vaporizer frame (46) on which the crucible (45) of the vaporizer (37) is supported.

7. Apparatus according to either of Claims 5 and 6, characterized in that the opening (61) in the darkroom screen (3) can be closed by a flap (62) and the machine frame (46) is connected to the voltage supply (42) in an electrically conductive manner by means of the lead (59).

8. Apparatus for coating substrates (31, 31', ...) in a vacuum chamber (2) having a substrate carrier (30) disposed therein and a device (29) for generating a plasma cloud (28) which comprises an electron emitter (11) with a tubular anode (38) which is connected downstream, which is provided with an inlet (10) for the process gas for igniting the plasma, and which is furthermore equipped with magnets (4, 7), an apparatus for generating atoms, molecules or clusters of the materials for generating the layer on the substrates (31, 31', ...), preferably an electron beam vaporizer (37), a thermal vaporizer or a sputter cathode being disposed opposite the substrate holder (30) in the process chamber (43), from which apparatus the vaporized or dust-like material (31) can be applied directly onto the substrates (31, 31', ...), characterized in that the device (29) is disposed such that it is electrically insulated with respect to the other parts of the apparatus in the interior of the vacuum chamber (2) and opposite the substrate carrier (30), it being possible for the electron emitter (11) to be connected to one pole and the anode tube (38) to be connected to the other pole of a current source (35) such that the electrons emerging from the electron emitter (11) and reflected externally of the device (29) can be guided back to the anode tube (38) along the field lines of the magnets (4, 7).

## Revendications

1. Dispositif pour le revêtement de substrats (31, 31', ...) dans une chambre à vide (2), comportant un porte-substrats (30) agencé dans celle-ci et un dispositif (29) pour la production d'un nuage de plasma (28), qui comporte un émetteur d'électrons (11) avec une anode tubulaire interconnectée (38), qui est pourvu d'une entrée (10) pour le gaz de traitement pour l'allumage du plasma et qui est en outre équipé d'aimants (4, 7), dans lequel en face du porte-substrats (30) dans la chambre de traitement est agencé un dispositif pour la production d'atomes, de molécules ou d'amas de molécules des matériaux pour la production de la couche sur les substrats (31, 31', ...), de préférence un vaporisateur à faisceau d'électrons (37), un vaporisateur thermique ou une cathode de pulvérisation, à partir duquel le matériau vaporisé ou pulvérisé (31) peut directement être déposé sur les substrats (31, 31', ...), caractérisé en ce que l'agencement magnétique (4, 7) qui entoure l'anode tubulaire (38) de la source (29), agencée directement à côté du vaporisateur (37) du même côté de la paroi de la chambre de traitement, est entouré d'un tube de blindage (5) et d'un blindage à espace sombre (3), et le nuage de plasma (28) sortant de l'anode (38) est défléchi sur le porte-substrats (30) agencé en face de la source (29), une répartition volumique du plasma (28) nécessaire pour un revêtement régulier pouvant être effectuée à l'aide des aimants (26, 27) agencés du côté du porte-substrats (30) détourné de la source (29).

2. Dispositif selon la revendication 1, caractérisé en ce que le porte-substrats (30) agencé de façon électriquement isolée par rapport à la paroi de la chambre de traitement (2) peut être raccordé au choix à un générateur à haute fréquence (34) ou à un poste-secteur à courant continu (35).

3. Dispositif selon l'une ou l'autre des revendications 1 et 2, caractérisé en ce que le porte-substrats (30) est formé essentiellement par un tronçon de tôle réalisé en forme d'écran pourvu d'une multitude de perçages (52, 52', ...), sur lequel est enfilé à distance un second tronçon de tôle (36) également en forme d'écran, les deux tronçons de tôle (25, 36) étant reliés solidairement en rotation à un arbre (49) à entraînement motorisé.

4. Dispositif selon l'une ou plusieurs des revendications précédentes, caractérisé en ce que la paroi intérieure de la chambre de traitement (43) est revêtue à distance d'une tôle perforée (25).

5. Dispositif selon l'une ou plusieurs des revendications précédentes, caractérisé en ce qu'un plasma (60) peut être produit entre le creuset (45) du vaporisateur à faisceau d'électrons (37) et le tube d'anode (38) de la source de plasma (29) en appliquant une différence de potentiel entre la source de plasma (29) et la chambre à vide (2), par un poste-secteur à courant continu (42) qui est raccordé à la cathode et à l'anode de cette décharge de plasma, de telle sorte que le creuset (45) forme la cathode pour le plasma et que le tube d'anode (38) de la source de plasma (29) forme l'anode pour le plasma, une ouverture (61) au voisinage du creuset (45) étant prévue dans le blindage à espace sombre (3) afin de réaliser une liaison directe pour les électrons de la décharge de plasma (60) au blindage de champ magnétique (5) qui est à son tour relié de façon conductrice au tube d'anode (38).

6. Dispositif selon l'une ou plusieurs des revendications précédentes, caractérisé en ce que le poste-secteur à courant continu (42) est raccordé par un de ses pôles via une première conduite électrique (58) au passage de haut courant qui se trouve à son tour en liaison avec le tube d'anode (38) de la source de plasma (29) via un tube de réfrigérant (22) conducteur de courant, le poste-secteur à courant continu (42) étant en liaison par son autre pôle via une seconde conduite électrique (59) avec le bâti (46) du vaporisateur sur lequel s'appuie le creuset (45) du vaporisateur (37).

7. Dispositif selon les revendications 5 et 6, caractérisé en ce que l'ouverture (61) dans le blindage à espace sombre (3) peut être fermée par un clapet (62) et le bâti (46) de la machine est en liaison électriquement conductrice avec l'alimentation en tension (42) via la conduite (59).

8. Dispositif pour le revêtement de substrats (31, 31', ...) dans une chambre à vide (2) comportant un porte-substrats (30) agencé dans celle-ci et un dispositif (29) pour la production d'un nuage de plasma (28), qui comporte un émetteur d'électrons (11) avec une anode (38) tubulaire interconnectée, qui est pourvu d'une entrée (10) pour le gaz de traitement pour l'allumage du plasma et qui est en outre équipé d'aimants (4, 7), dans lequel en face du porte-substrats (30) dans la chambre de traitement (43) est agencé un dispositif pour la production d'atomes, de molécules ou d'amas de molécules des matériaux pour la production de la couche sur les substrats (31, 31', ...) de préférence un vaporisateur à faisceau d'électrons (37), un vaporisateur thermique ou une cathode de pulvérisation, dispositif à partir duquel le matériau vaporisé ou pulvérisé (31) peut être directement déposé sur les substrats (31, 31', ...), caractérisé en ce que le dispositif (29) est agencé dans l'intérieur de la chambre à vide (2) en face du porte-substrats (30) de façon électriquement isolée par rapport aux autres parties du dispositif, l'émetteur d'électrons (11) pouvant être raccordé à un des pôles et le tube d'anode (38) à l'autre pôle d'une source de courant (35), de sorte que les électrons sortant de l'émetteur d'électrons (11) et réfléchis hors du dispositif (29) peuvent être renvoyés vers tube d'anode (38) le long des lignes de champ des aimants (4, 7).
